Europäisches Patentamt

European Patent Office

Office européen des brevets

(19)

(11) Publication number: **0 081 568**
**B1**

# EUROPEAN PATENT SPECIFICATION

(45) Date of publication of patent specification: **29.10.86**    (51) Int. Cl.⁴: **H 03 M 3/02**

(21) Application number: **82902232.6**

(22) Date of filing: **04.06.82**

(88) International application number:
**PCT/US82/00765**

(87) International publication number:
**WO 82/04508 23.12.82 Gazette 82/30**

(54) **ENHANCED DELTA MODULATION ENCODER.**

<table>
<tr><td>

(30) Priority: **12.06.81 US 272983**

(43) Date of publication of application:
**22.06.83 Bulletin 83/25**

(45) Publication of the grant of the patent:
**29.10.86 Bulletin 86/44**

(84) Designated Contracting States:
**DE FR GB**

(56) References cited:
**US-A-3 244 808**
**US-A-3 462 686**
**US-A-3 462 686**
**US-A-3 562 420**
**US-A-3 918 042**
**US-A-4 071 842**
**US-A-4 161 633**
**US-A-4 313 204**

**ELECTRONICS LETTERS, vol. 12, no. 15, 22nd
July 1976, pages 379-380, Hitchin, GB, J.D.
EVERARD: "Improvements to Delta-Sigma
modulators when used for P.C.M. encoding.**

</td><td>

(73) Proprietor: **GOULD INC.**
**10 Gould Center**
**Rolling Meadows, IL 60008 (US)**

(72) Inventor: **HARRIS, Robert W.**
**1702 Fallsway Drive**
**Crofton, MD 21114 (US)**

(74) Representative: **Barrett, James William et al**
**A.A. THORNTON & CO. Northumberland House**
**303-306 High Holborn**
**London WC1V 7LE (GB)**

</td></tr>
</table>

Courier Press, Leamington Spa, England.

## Description

This invention relates to analog-to-digital encoders and in particular to an enhanced analog-to-digital encoder which employs delta modulation.

There is a wide range of commercial, industrial, scientific and military systems which are employed for high accuracy sensing of a variety of physical phenomena. Many of these systems convert the sensed analog data to digital data which may be readily transmitted and processed without degrading the dynamic range, resolution, phase or linearity of the data. In these systems the analog signals provided by the sensors (e.g., microphones, hydrophones, geophones, optical sensors, infrared sensors, image scanners, magnetic field sensors, etc.) are prepared for digitization by signal conditioning electronics including for example, pre-amplifiers, equalizers, controlled gain circuits, anti-alias filters, sample and hold circuits, etc. The conditioned analog signals are then digitized by analog-to-digital encoders. The primary cause for limited data fidelity and inadequate system performance is the distortion and noise introduced into the data signal by the A/D encoder and by the signal conditioning electronics.

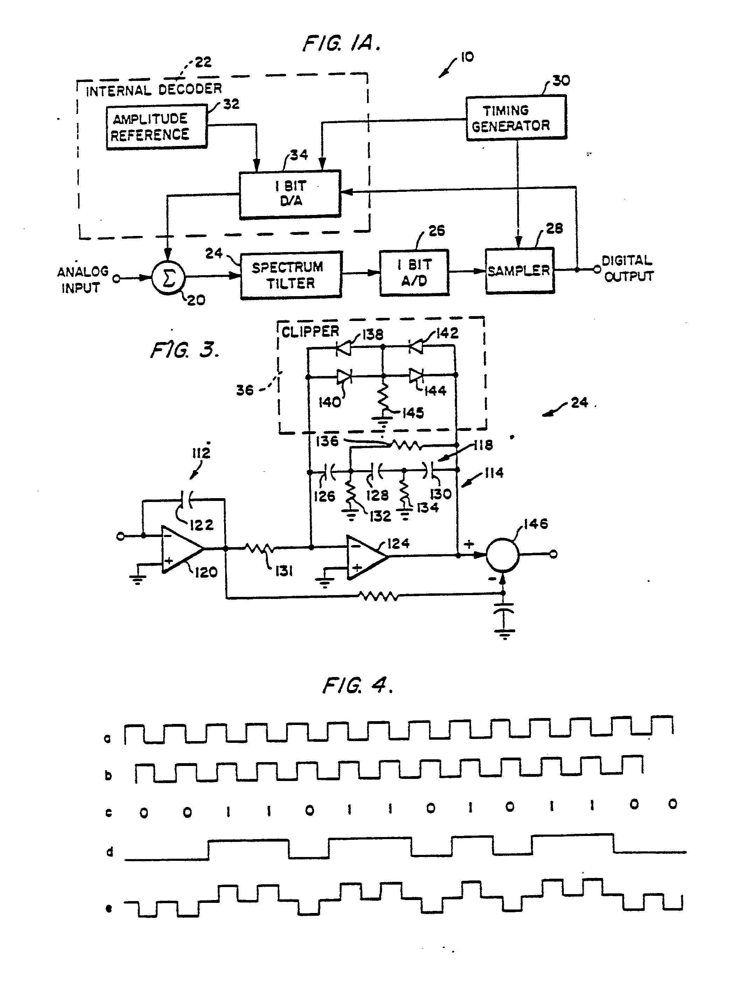

In the prior art, U.S. patent 3,918,042 (Werner) is directed to a delta modulator including a filter 22 and a nonlinear element 24 (Fig. 1). The filter 22 includes an integrator for providing an output which varies with the average amplitude of the pulse wave applied thereto. The output of the filter 22 is applied to the nonlinear element 24 which translates the signal in a linear manner until the signal reaches a predetermined amplitude. Above this predetermined amplitude, the signal is translated in a linear manner at a higher gain.

U.S. Patent 4,071,842 (Tewksbury) discloses predictive and error feedback coders which sample the analog signal at generally high rates and provide a differential pulse code modulation output. In particular, the Tewksbury patent is directed to reducing the number of levels required in a quantizer, while maintaining the feedback network independent of the input signal. The Tewksbury patent produces these results in the case of predictive coders by including a chain of $n$ integrators (arranged so that the signal feedback to a comparator is the sum of single, double, triple ... n order integration) in the feedback loop (Fig. 4). With respect to error feedback coders, serial chains of $n$ integrators are employed both in the coder input line and in the feedback loop (Fig. 8).

In Electronics Letters, Volume 12, No. 15, 22nd January 1976, pages 379—80, there is disclosed a PCM encoder including a single integrator and including a DC offset correction scheme.

In most systems, the best fidelity achievable by current A/D encoders with their corresponding signal conditioning circuits is 90—100 dB of signal to distortion ratio (SDR). Although there is no single universally applicable measure of A/D encoder fidelity (because of the many different applications and environments in which A/D encoders are employed), the signal to distortion ratio defined below is an accurate measure for a broad range of A/D applications.

As defined, the SDR does not encompass DC offset, scale factor error, or phase delay distortion. The SDR (as defined below) encompasses the following A/D encoder errors and performance terms: non-linearity (linearity); differential non-linearity (differential linearity); harmonic distortion; intermodulation distortion; quantizing noise; all other noise (Johnson, Gaussian, etc.); clipping, dynamic range (instantaneous, two-tone); resolution; and monotonicity. Thus, it can be seen from the above list, that the signal to distortion ratio (SDR) takes into account a large number of considerations relevant in the measure of A/D encoder fidelity.

In order to determine the SDR, a maximum signal frequency $F_{ms}$, which is the maximum frequency of interest in the spectrum of the sensed analog signal to which the A/D encoder will be applied, is assumed. Two sine wave tones (having tone frequencies of, for example, 71% and 83% of $F_{ms}$ and having equal amplitude) are combined and fed as an input test signal to the A/D encoder input. The A/D encoder output is subjected to spectral analysis and the distortion power is defined as the sum of all the A/D output power from zero frequency to $F_{ms}$ except for the energy right at zero frequency and that at the two frequencies in the input test signal. (Any noise which is lost in notching out zero frequency and the two test signal frequencies is estimated and added to the measured distortion power.) The sine wave equivalent signal power is defined as the square of the sum of the RMS amplitudes of the two tones in the input test signal, measured at the A/D encoder output. (This definition of sine wave equivalent signal power gives the power of a single tone test signal which would have the same peak to peak amplitude as the actual two-tone test signal.) The signal to distortion ratio (SDR) is defined as the maximum obtainable ratio, as the input signal strength is varied, of the above-defined sine wave equivalent signal power to the above-defined distortion power, and is conventionally expressed in decibels (dB). For A/D encoders which require that a sample and hold circuit precede them, the SDR is measured on the combined sample and hold circuit and A/D encoder.

There are a number of existing classes of methods for A/D encoding, including:
  1. Integrate and Count
     Voltage-to-Frequency and Count
  2. Successive Approximation
  3. Delta Modulation
     Delta Sigma Modulation
  4. Flash Conversion
  5. Josephson Junction Devices

The class 1 encoders (Integrate and Count and Voltage-to-Frequency and Count) are very slow and are used mainly in digital volt meters and digital multimeters where the measured analog signal is assumed to be stationary.

The class 2 encoders (Successive Approximation) cannot maintain signal to distortion ratio performance above 90—100 dB because of drift, with time and temperature, of resistor (or capacitor) ratios. These encoders have extremely high sensitivity to component ratios, and require a sample and hold circuit and an anti-alias filter to precede them in most applications. These additional circuits can add substantial distortions to the system. Despite the drawbacks of class 2 encoders, they offer the best performance of the five above-mentioned classes for a broad range of applications.

The class 3 encoders (Delta Modulation and Delta Sigma Modulation) generate data too voluminously, for example, a single integrator implementation of this class of encoder generates 20,000 bits per cycle of input signal at the maximum frequency of interest ($F_{ms)}$ in order to achieve 120 dB of SDR. This high output data rate relative to the true information content causes untoward difficulties in processing, storing and transmitting the data. The SDR of this class of encoder is governed by a noise floor of so-called "granular noise" (which is a form of quantizing noise). A single integrator implementation of this class of encoder gains only 9 dB of granular noise reduction, and thus gains only 9 dB of SDR, for each doubling of its output bit rate relative to the maximum frequency of interest of its input signal. Therefore, the bit rate required grows exponentially with increasing SDR. Due to this exponential bit rate growth, this class of encoder is most useful for low SDR applications. Double integration implementations of this class of encoder can achieve 15 dB of SDR growth per doubling of bit rate and are therefore useful for applications of medium SDR. However, even with double integration the output bit rate is impractically high for applications requiring 100 dB or more of SDR.

The class 4 encoders (Flash Conversion) are limited to low SDR applications (approximately 60 dB) since each additional 6 dB of SDR doubles the complexity of the flash converters. Thus, the flash converters are not suitable for high SDR (100 dB or more) applications but instead are more suitable for very high bandwidth signals.

The class 5 encoders (Josephson Junction devices) are not in present commercial use. These devices will operate on the unique quantizing properties of Josephson junctions and offer very high speed and accuracy. However, they will require a cooling system to keep them within several degrees of absolute zero, thereby making them suitable only for specialized applications.

In summary, there is a need in the art for an analog-to-digital encoder having a high signal-to-distortion ratio, having a low data rate relative to the signal frequency bandwidth of interest, and having a reduced amount of granular noise.

Summary of the Invention

It is an object of the present invention to provide an analog-to-digital encoder which overcomes the deficiencies of prior art encoders.

In particular, it is an object of the present invention to provide an analog-to-digital encoder having a signal to distortion ratio of at least 120 dB.

It is a further object of the present invention to provide an analog-to-digital encoder which reduces signal conditioning errors and cost by overcoming the necessity of providing a sample and hold circuit, an anti-alias filter and a controlled gain amplifier which are required in certain existing analog to digital encoders.

A still further object of the present invention is to provide an analog-to-digital encoder having a lower data output rate then existing delta modulation encoders and delta sigma modulation encoders, while providing comparable or better SDR performance for the same frequency band of interest.

As seen from one aspect, the present invention provides an analog-to-digital encoder for converting an analog input signal, having a predetermined frequency band of interest, to a digital output, including first means for receiving the analog input signal and generating an analog dither signal, second means for generating the digital output, and third means for feeding back the digital output to said first means by generating an internal analog signal and providing the internal analog signal to said first means, said first means adding the analog input signal and the internal analog signal to obtain the analog dither signal, characterized in that said analog-to-digital encoder further comprises:

a spectrum tilter, operatively connected to said first means, for receiving the analog dither signal and for generating a flattened analog signal, said spectrum tilter having more than 180° of phase lag at certain frequencies within the frequency band of interest, said spectrum tilter including means for preventing said analog-to-digital encoder from entering a limit cycle, said second means generating the digital output on the basis of the flattened analog signal.

As seen from another aspect the invention provides an analog-to-digital encoder for converting an analog input signal, having a predetermined frequency band of interest, to a digital output, including first means for receiving the analog input signal and generating an analog dither signal, second means for generating a digital output, and third means for receiving the digital output and for generating an internal analog signal, characterized in that said analog-to-digital encoder further comprises:

A first spectrum tilter, operatively connected to said first means and said second means, for receiving the analog dither signal and for generating a flattened analog signal; and

a second spectrum tilter, operatively connected to said third means and said first means, for receiving the internal analog signal and for generating a flattened internal analog signal, said first means adding the analog input signal and the flattened internal analog signal to obtain the analog dither signal, said first and second spectrum tilters together generating more than 180° of phase lag at certain frequencies within the frequency band of interest, at least one of said first and second spectrum tilters including means for preventing said analog-to-digital encoder from entering a limit cycle.

The analog-to-digital encoder of the present invention has a number of unique features and advantages as set forth below. The analog-to-digital encoder of the present invention is an enhanced delta modulation encoder (EDME) which employs the established delta modulation technique in an entirely novel manner. The enhanced delta modulation encoder of the present invention performs A/D encoding with higher accuracy, linearity, dynamic range and signal-to-distortion ratio than previously possible for signals of bandwidth in the range of approximately 300 Hz to 300 kHz. It is capable of at least 120 dB of SDR performance over most of this range, while the next best method of A/D conversion in this frequency range (Successive Approximation) is limited to 90 to 100 dB of SDR. Further, the SDR of the enhanced delta modulation encoder of the present invention is more stable with time and temperature than that of the successive approximation encoder. Below 300 Hz signal bandwidth, the enhanced delta modulation encoder's excellent SDR can be matched by delta sigma modulation and delta modulation encoders. However, the enhanced delta modulation encoder of the present invention has a much lower output bit rate than either of these encoders. The enhanced delta modulation encoder can reduce system size, power and cost when replacing the successive approximation encoder because it eliminates the need for anti-alias filter and a sample and hold circuit. A total system employing enhanced delta modulation encoding contains fewer non-integrable analog components than does the system employing a successive approximation encoder. Furthermore, the decoder which may be employed to decode the output of the enhanced delta modulation encoder has a much lower cost than does the decoder for other A/D encoders except for the delta modulation encoder and the delta sigma modulation decoder. This feature is potentially beneficial for the future of digital audio high fidelity recording. Thus, recording enhanced delta modulation encoder code on records could reduce player cost since any player for digital hi-fi records will include a decoder.

The enhanced delta modulation encoder of the present invention includes a spectrum tilter which makes the encoder of the present invention capable of achieving very high fidelity A/D encoding (at least 120 dB of SDR) while avoding the impractically high bit rates which are required by existing delta modulation and delta sigma modulation encoders. For example, the enhanced delta modulation encoder of the present invention achieves high fidelity (at least 120 dB of SDR) at approximately 1/100th of the clock rate required by delta modulation encoders and delta sigma modulation encoders implemented by a single integrator. In addition, the enhanced delta modulation encoder of the present invention achieves high fidelity at a substantially lower clock rate than that required by delta modulation encoders and delta sigma modulation encoders implemented by a double integrator.

The enhanced delta modulation encoder output can be digitally processed using standard digital filter technology. Signal conditioning such as equalization and band limiting which is conventionally done prior to A/D encoding may now be done digitally after enhanced delta modulation encoder encoding. An enhanced delta modulation encoder with a programmable digital post processor can thus implement an encoder with programmable signal conditioning. This approach (shifting the signal conditioning to the digital domain) enables the signal conditioning to be more accurate and more stable than analog domain signal conditioning. In addition, it allows the signal conditioning to be programmable. The high dynamic range of the enhanced delta modulation encoder makes this approach possible. A digital post-processor connected to the enchanced delta modulation encoder can convert its data format to a multi-bit per sample form at a reduced sample rate. The sample rate must only meet the Nyquist criterion for the signal as it exists after any signal conditioning. Since a digital post-processor can implement stable and accurate anti-alias filtering, the enhanced delta modulation encoder connected to a post-processor can operate in the same manner as the successive approximation encoder output format, without incurring the phase and gain drift, the noise, the phase delay distortion, etc. of an analog anti-alias filter.

The serial, wordless, bit democratic nature of the enhanced delta modulation encoder output is an advantage in many cases. In can reduce the complexity of telemetry or recording and playback hardware in applications where the A/D encoder output must be telemetered or recorded, because telemetry channels and recording media generally provide a bit serial format.

These together with other objects and advantages which will become subsequently apparent, reside in the details of construction and operation as more fully hereinafter described and claimed, reference being had to the accompanying drawings forming a part hereof, wherein like numerals refer to like parts throughout.

Brief Description of the Drawings

Figure 1A is a block diagram of the enhanced delta modulation encoder of the present invention;

Figure 1B is a block diagram of an alternate embodiment of the enhanced delta modulation encoder of the present invention;

Figures 2A and 2B comprise a circuit diagram of the enhanced delta modulation encoder illustrated in Figure 1A, including a first embodiment of the spectrum tilter 24 of Figure 1A;

Figure 3 is a circuit diagram of a second embodiment of the spectrum tilter 24 of Figure 1A;

Figure 4 is a timing diagram for illustrating the various signals described with reference to Figure 1A;

Figure 5 is a timing diagram for illustrating the various signals described with reference to Figures 2A and 2B;

Figure 6 is a graph for illustrating the gain of the spectrum tilter 24 and the spectral density of the internal analog dither signal provided to the spectrum tilter 24 of Figure 1A; and

Figure 7 is a block diagram illustrating an embodiment of a decoder which can be employed to decode the digital output of the enhanced delta modulation encoder of Figure 1A.

Detailed Description of the Preferred Embodiments

Figure 1A is a block diagram of the enhanced delta modulation encoder 10 of the present invention, in which an analog summer 20 forms an analog dither signal by summing an analog input signal and an internal analog signal generated by an internal decoder 22. A spectrum tilter 24 processes the analog dither signal and generates a flattened analog signal. Under normal signal conditions, the spectrum tilter 24 functions as a linear analog filter. A 1 bit A/D converter 26, which is a comparator in the preferred embodiment, converts the polarity of the tilted analog signal to a digital signal. A sampling circuit 28 periodicially samples the digital signal output by the 1 bit A/D converter 26, in dependence upon a timing signal from a timing generator 30, so that the bit rate of the digital output is governed by the timing signal generated by the timing generator 30 and generates the enhanced delta modulation encoder's digital output which is a serial bit stream. The enhanced delta modulation encoder output is a serial bit stream without word boundaries (although it can be transmitted or stored, etc., in words of any convenient size). Thus, the enhanced delta modulation encoder 10 produces a digital output in which, in any decoding process, the bits have equal weight and each bit is operative at a unique time. In contrast, the digital output of an N-bit sampling A/D encoder (i.e., any of the A/D encoders from the above-mentioned classes 1—2 and 4—5) has an inherent word structure with N-bits per word, and with a ranking of bits within the word. The lack of word structure in the enhanced delta modulation encoder's output simplifies its transmission, recording, storage, and playback, because the transmission or recording medium need not contain word boundary information. In the preferred embodiment, the sampling circuit 28 comprises a 1 bit digital sampler or a flip-flop.

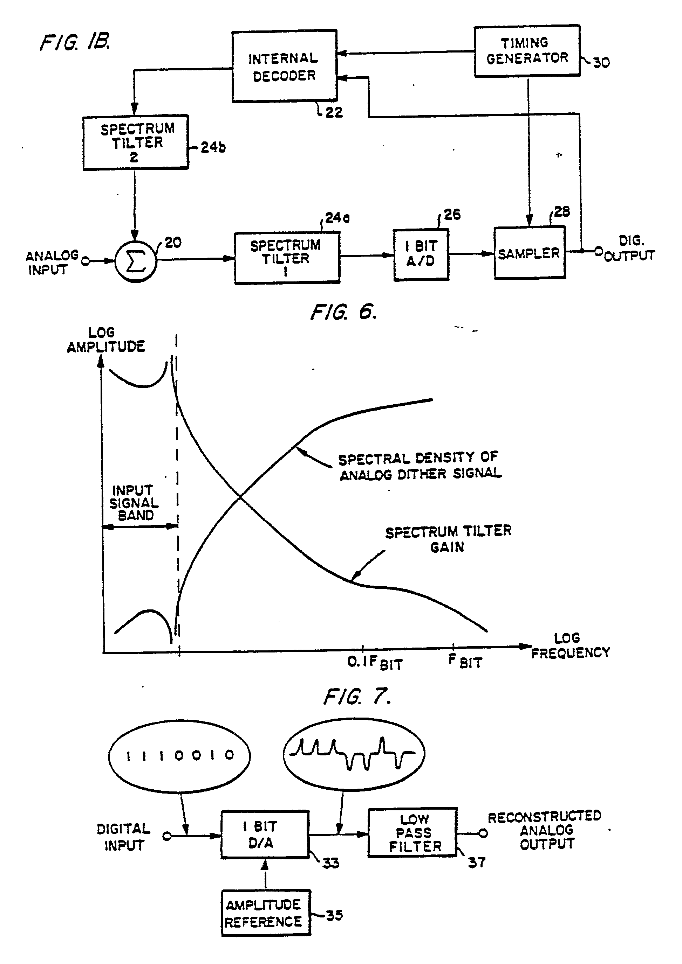

The digital output of the sampling circuit 28 is fed back to the internal decoder 22 which receives a timing signal from the timing generator 30. The internal decoder 22 comprises an amplitude reference 32 and a 1 bit digital-to-analog converter 34. The 1 bit digital-to-analog converter generates the internal analog signal in dependence upon the digital output and the timing signal from the timing generator 30. The internal analog signal is a pulse signal in which one pulse is generated for each bit of the digital output. The area under a particular pulse is determined by the corresponding bit of the digital output from two possible values supplied by the amplitude reference 32. The analog input signal is a signal having spectral contents in a predetermined frequency band of interest. In addition, the analog input signal may have spectral contents outside the frequency band of interest. The analog input signal and the internal signal are summed together to form an analog dither signal. The portions of the analog input signal within the frequency band of interest cancel with the portions of the internal analog signal which are within the frequency band of interest. The spectral content of the analog dither signal within the frequency band of interest is very low. The feedback, i.e., the internal analog signal, tracks the input analog signal for the frequency band of interest because in that region the spectrum tilter has a very high gain. Referring to Figure 6, it has been experimentally demonstrated that the spectral shape of the flattened analog signal at the output of the spectrum tilter 24 is flat. This is equivalent to stating that the spectral shape of the analog dither signal closely approximates the inverse of the frequency response of the spectrum tilter 24. The spectrum tilter 24 has very high gain within the input signal spectral band, thus the analog dither signal has very little energy in the frequency band of interest. The low spectral density of the analog dither signal within the analog input signal's frequency band of interest indicates that the internal analog signal which is output by the internal decoder 22 tracks the analog input signal accurately within the analog input signal's frequency band of interest. Since the output of the internal decoder 22 is generated from the digital output of the sampling circuit 28, the digital output contains sufficient information to reconstruct an accurate image of the analog input signal.

The enhancement feature of the enhanced delta modulation encoder 10 is governed by the degree of tilt in the spectrum tilter 24. The accuracy of the enhanced delta modulation encoder 10 is proportional to the effective gain of the spectrum tilter within the analog input signal spectral band, divided by the spectrum tilter's effective gain in the vicinity of the bit rate frequency $F_{BIT}$ down to approximately .1 $F_{BIT}$.

Referring to Figure 4, the various signals which have been discussed with respect to Figure 1 are described. Row *a* of Figure 4 illustrates the timing signal which is transmitted from the timing generator 30 to the sampling circuit 28. Row *b*

illustrates the timing signal which is transmitted from the timing generator 30 to the 1 bit digital-to-analog converter 34 in the internal decoder 22. Row $d$ of Figure 4 illustrates the digital output signal which is output by the sampling circuit 28. Row $c$ of Figure 4 illustrates a data string comprising "0" and "1" bits, which is the data domain representation of the output signal which is output by the sampling circuit 28. As illustrated in rows $a$ and $d$ of Figure 4, the bit rate of the digital output signal (row $d$) is governed by the timing signal (row $a$). Row $e$ in Figure 4 illustrates the internal analog signal which is generated by the 1 bit D/A converter 34 in the internal decoder 22. As illustrated in row $e$, the internal analog signal is a pulse signal which is dependent upon the timing signal (row $b$) and the data value of the digital output signal (row $c$).

A key element of the enhanced delta modulation encoder 10 is the spectrum tilter 24. As noted above, the spectrum tilter normally functions as a linear filter and, as a result, the desirable tilt which is produced by the spectrum tilter 24 also causes a phase lag which threatens the stability of the negative feedback loop of the encoder. In linear system control theory, a rule of thumb for stabilizing negative feedback loops states that if the phase lag is maintained at less than 180° at all frequencies up to the frequency of unity loop gain, the feedback loop will be stable. In fact, the more accurate statement of the law is that there can be any phase lag (including greater than 180°) below the unity loop gain frequency but the phase lag must be less than 180° at the unity loop gain frequency. Thus, if the phase lag is greater than 180° at low frequencies (below unity gain) then a conditionally stable system exists, so that if the loop gain is reduced sufficiently to bring the unity loop gain frequency down into a region where there is more than 180° of phase lag, the system becomes unstable.

The spectrum tilter 24 has less than 180° of phase lag in the frequency region from approximately $.1F_{BIT}$ to $F_{BIT}$ and substantially more than 180° of phase lag below $.1F_{BIT}$. The tilt is correspondingly strong below $.1F_{BIT}$ and week between $.1F_{BIT}$ and $F_{BIT}$. The relatively low phase lag in the region from $.1F_{BIT}$ to $F_{BIT}$ provides the enhanced delta modulation encoder feedback loop with a stable operating mode. However, the existence of a greater than 180° phase lag at frequencies below $.1F_{BIT}$ means the enhanced delta modulation encoder feedback loop has the potential for limit cycles, i.e., self-sustaining abnormally large signals in the feedback loop. For this reason, the spectrum tilter 24 includes a clipper 36 (see Figure 3) which reduces the phase lag to less than 180° at all frequencies below $F_{BIT}$ whenever any abnormally large signal occurs within the spectrum tilter 24. Thus, since limit cycles are characterized by abnormally large signals within the spectrum tilter 24, the clipper 36 prevents limit cycles from persisting. Although the clipper is a non-linear element and its phase lag reduction carries a concomitant reduction in spectral tilt, it does not interfere with the normal action of the spectrum tilter 24 because during normal operation of the enhanced delta modulation encoder 10 the signal level in the spectrum tilter 24 is below the threshold of the clipper 36, i.e., the clipper 36 is inactive. Thus, the clipper 36 makes possible the large spectrum tilt which is responsible for the suppression of granular noise within the input signal spectral band of interest. Without the clipper 36, the enhanced delta modulation encoder 10 could go irreversibly into a limit cycle at power-up time or following an external disturbance such as a transient occurring on its power supplies, its input signal going beyond full scale, or a burst of RF energy impinging on it.

Figure 7 illustrates a block diagram of an embodiment of an external decoder which may be employed to decode the digital output signal of the enhanced delta modulation encoder 10 of the present invention. The external decoder includes a one bit digital-to-analog converter 33, an amplitude reference 35 and a low pass filter 37. The one bit D/A converter 33 converts the digital input bit stream (which is the same as the digital output of the enhanced delta modulation encoder 10) at one pulse per bit. The area under a particular pulse is determined by the corresponding bit of the digital output (i.e., the input bit stream to the decoder) from two possible values supplied by the amplitude reference 35. A low pass filter 37 passes all of the energy in the pulse stream which is spectrally less than or equal to the maximum signal frequency of interest $F_{ms}$ and filters out the energy which is spectrally above $F_{ms}$. The pulse train which is output by the one bit D/A converter 33 comprises a "true signal image" mixed together with a "dither signal". The dither signal is the difference between the pulse train of fixed size pulses and the true signal image. The low pass filter 37 filters out most of the dither signal because most of the energy in the dither signal lies spectrally above $F_{ms}$. The output of the decoder contains, as noise, only that portion of the dither signal which lies spectrally at or below $F_{ms}$.

It should be noted that the decoder of Figure 7 is also a decoder which can be used with the delta sigma modulation encoder. The performance enhancement of the enhanced delta modulation encoder of the present invention over the delta sigma modulation encoder is due to the fact that the enhanced delta modulation encoder 10 reduces, to a greater extent, that portion of the analog dither signal which lies spectrally at or below $F_{ms}$. The enhanced delta modulation encoder 10 does this by tilting, to a greater extent, the spectrum of the analog dither signal, thereby moving more of the analog dither signal noise out of the signal pass band, allowing it to be eliminated by the low pass filter 37.

The true signal image which exists in the pulse train which is output by the one bit D/A converter 33 is not limited to frequencies at or below $F_{ms}$ but is a broad band image of the analog input signal. The true signal image consists of all the energy in the analog input signal which lies spectrally below half of the enhanced delta modulation encoder output bit rate. Input energy at frequencies up to half of the bit rate is not aliased (i.e., shifted to a different frequency). Input energy above half of the bit rate is aliased, but it is also attenuated to the extent that its strength at the new frequency is comparable to the strength of the dither signal at that frequency. Therefore, aliasing is not a problem in the enhanced delta modulation encoder 10 of the present invention and, as a result, the enhanced delta modulation encoder 10 requires neither an anti-alias filter nor a sample and hold circuit to precede it.

Since the true signal image within the pulse train output by the one bit D/A converter 33 contains a broad band image and is not limited to energy spectrally at or below some $F_{ms}$, the value of $F_{ms}$ can be changed by merely changing the cut-off frequency of the low pass filter 37 in the decoder (Figure 7). The enhanced delta modulation encoder 10 does not need to be modified to change the maximum frequency of interest because the enhanced delta modulation encoder 10 normally encodes the input signal at frequencies far above the maximum frequency of interest.

In contrast to the decoder (Figure 7) for the enhanced delta modulation encoder 10 of the present invention, the decoder for the delta modulation encoder requires that an analog integrator be connected between the one bit D/A converter 33 and the low pass filter 37. The integrator required in the decoder for the delta modulation encoder is tied in with several characteristic differences between the delta modulation encoder on the one hand, and the delta sigma modulation encoder and the enhanced delta modulation encoder 10 on the other hand. Thus, the delta modulation encoder has a large DC uncertainty and cannot effectively encode the DC portion of its input, whereas the enhanced delta modulation encoder 10 is capable of encoding DC and AC signals. In addition, the delta modulation encoder goes into overload at a particular signal slope, while the enhanced delta modulation encoder 10 goes into overload at a particular signal amplitude. As a result, the maximum sine wave signal capability of the data modulation encoder is inversely proportional to the sine wave frequency, whereas the maximum sine wave signal capability of the enhanced delta modulation encoder 10 is independent of frequency. Therefore, the enhanced delta modulation encoder 10 has advantages over the delta modulation encoder because it has no slope limiting and no DC ambiguity.

The decoder illustrated in Figure 7 can be implemented digitally as a digital low pass filter having a single bit per sample input from the enhanced delta modulation encoder 10 and having a multi-bit per sample output, and the output sample rate can be reduced by decimation (i.e., discarding selected samples) as long as the Nyquist criterion is observed. In practice, the output sample rate can be reduced to approximately 2.5 $F_{ms}$ depending on the low pass filter cut-off rate. The digital low pass filter and decimator convert the enhanced delta modulation encoder output to the output code and format of an N-bit sampling A/D encoder. Since this is a digital process, it can be designed to maintain the data's signal to distortion ratio (SDR) and the output of the enhanced delta modulation encoder 10 can be converted (without loss of SDR) to a widely used code having the minimum practically achievable bit rate.

Figure 1B illustrates an alternate embodiment of the enhanced delta modulation encoder of the present invention where the spectrum tilter 24 is split into spectrum tilter one 24a and spectrum tilter two 24b. The special tilt which is produced by the spectrum tilter 24 may be inserted any place in the negative feedback loop to achieve the desired features of the present invention.

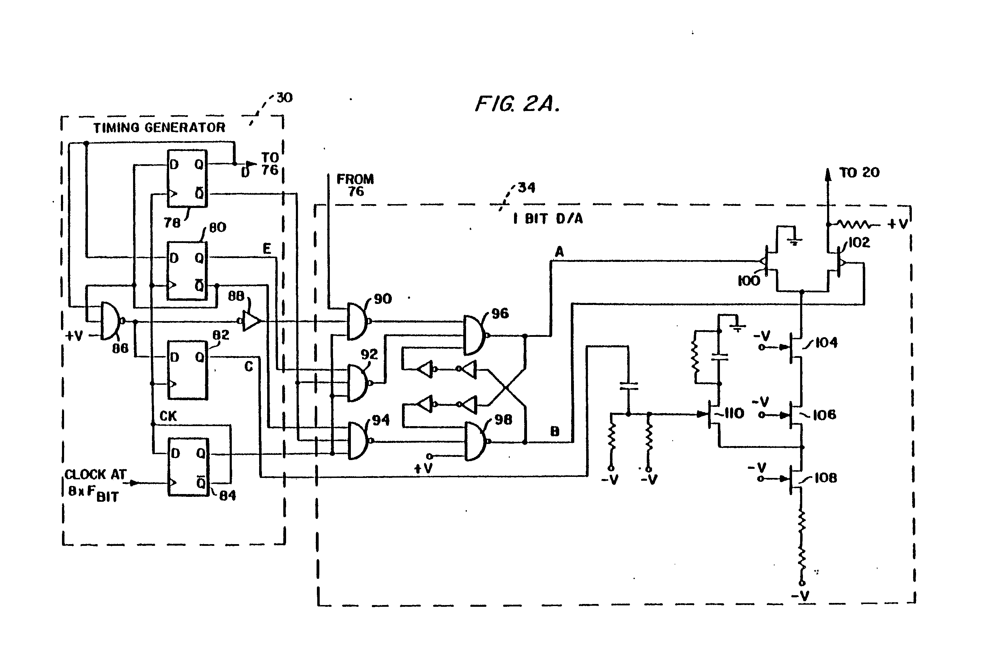

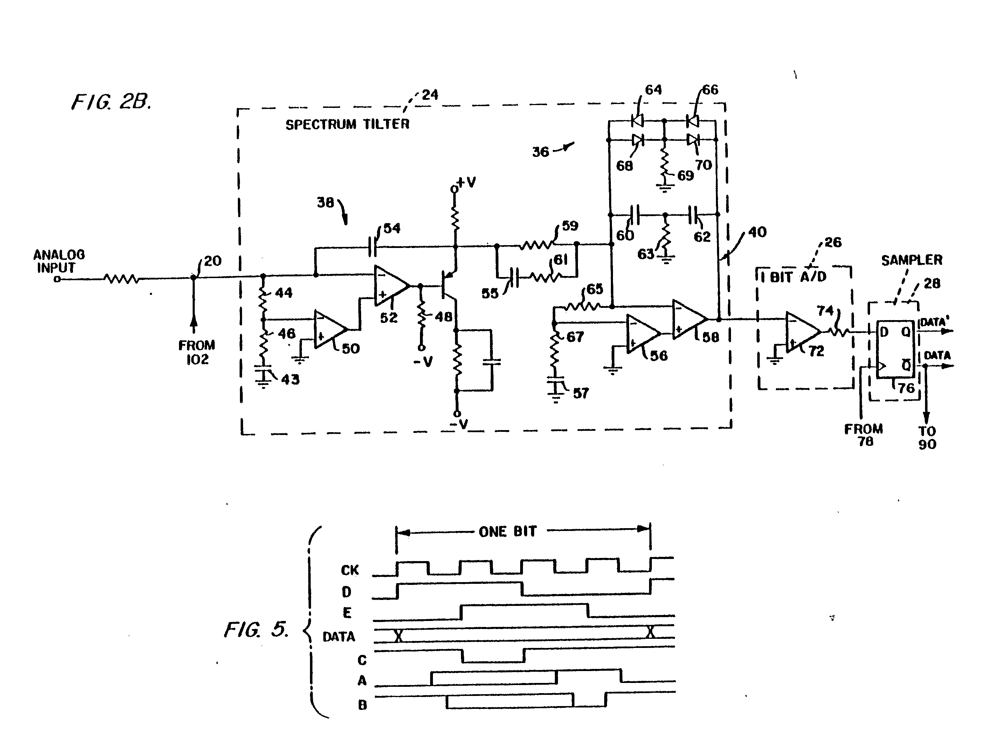

Referring to Figures 2A and 2B, a circuit diagram of the enhanced delta modulation encoder 10, including a first embodiment of the spectrum tilter 24, will be described.

The spectrum tilter 24 comprises three integrating circuits, which are implemented in this embodiment by an integrator 38 and a double integrator 40. The integrator 38 includes capacitor 43, resistors 44, 46 and 48, operational amplifiers 50 and 52, and an integrating capacitor 54. Resistors 44 and 46 and capacitor 43 provide compensation so that operational amplifiers 50 and 52 cooperate to function as a single high quality operational amplifier. The double integrator 40 includes operational amplifiers 56 and 58, capacitors 55 and 57, resistors 59, 61, 63, 65 and 67, and integrating capacitors 60 and 62. Operational amplifiers 56 and 58, resistors 65 and 67 and capacitor 57 function in a manner similar to the previously described operational amplifiers 50 and 52, resistors 44 and 46 and capacitor 43. Capacitor 55 and resistor 61 provide phase lead in the vicinity of or above the frequency of the bit rate. The resistor 63 establishes a zero of response in the complex frequency plane, which gives the double integrator 40 its double integrating characteristic. The clipper circuit 36 comprises four diodes 64, 66, 68 and 70 and resistor 69. With respect to this embodiment of the spectrum tilter 24, the phase lag below .1$F_{BIT}$ approaches 270°: 90° for each of the integrating capacitors 54, 60 and 62. The clipper 36 nullifies 180° of this phase lag by effectively by-passing two of the integrating capacitors 60 and 62. Thus, the stability of the enhanced delta modulation encoder 10 is maintained.

The 1 bit A/D converter 26 comprises a comparator 72 and a resistor 74. The sampling circuit 28 comprises a flip-flop 76 which receives the digital signal from the resistor 74 and the timing signal from the timing generator 30, and which generates the digital output from its $\overline{Q}$-output.

The timing generator 30 comprises four flip-flops 78, 80, 82 and 84, a NAND gate 86 and an inverter 88. The timing generator 80 generates a number of timing signals described below. The flip-flop 78 provides the timing signal, corresponding to row *a* in Figure 4, to the sampling circuit 28 comprising the flip-flop 76. The remaining timing signals, corresponding to row *b* in Figure 4, are provided to the 1 bit digital-to-analog converter 34 in the internal decoder 22.

The 1 bit digital-to-analog converter 34 comprises NAND gates 90, 92 and 94 which receive timing signals from the timing generator 30. The NAND gate 90 also receives the digital data output from the sampling circuit 28 comprising the flip-flop 76. The 1 bit digital-to-analog converter 34 further comprises NAND gates 96 and 98 which provide switching signals A and B. In the preferred embodiment, the 1 bit digital-to-analog converter 34 is a charge pump and further includes P channel J FETS 100 and 102 which are turned on and off by the switching signals A and B. The charge pump 34 further comprises a ladder including transistors 104, 106, 108 and 110. In the preferred embodiment, transistor 108 provides a predetermined constant current. Transistors 106 and 110 direct the predetermined constant current alternatively so that when the current flows through transistor 110 it goes to ground and has no effect. When the current is directed through transistor 106 it flows through transistor 104 and is switched so that it flows either through transistor 100 to ground or through transistor 102, in dependence upon the switching signals A and B. If the transistor 102 is turned on and the current is directed through transistors 106 and 104, then the current is provided to the analog summer 20 which in the preferred embodiment is a current summing node 20. Thus, the current is directed through the chain of transistors 108, 106, 104 and 102, and is injected into the summing node 20 for a specific length pulse anytime a "1" bit is present at the digital output. The transistors 110 and 106 chop the predetermined constant current into pulses so that current is intermittently provided through transistors 104 and 106.

Figure 5 is a graph illustrating the various signals corresponding to the letters referenced in Figures 2A and 2B. Figure 5 illustrates a timing diagram for a single bit time and the X's (DATA) illustrate where the data can change. A clock signal CK provides four cycles per bit time. The timing signals D and E are always the same regardless of the logic value of the data signal. The timing signal C is always a down-going pulse near the middle of the bit time. When C is low, a current pulse flows through the transistors 104 and 106, and the transistors 100 and 102 are exposed to the current pulse. The timing signals A and B control transistors 100 and 102 in a data dependent manner such that transistors 100 and 102 never switch while they are exposed to a current pulse. Thus, each current pulse provided by transistors 104 and 106 is directed in its entirety to ground or to the summing junction 20. The timing signals A and B are generated so that there is a break before make action on the switches 100 and 102. This is done by staggering the edges of timing signal A with respect to the edges of timing signal B so that they are never simultaneously low, and thus transistors 100 and 102 are never simultaneously turned on.

Referring to Figure 3, the spectrum tilter 24 comprises four integrating circuits which are implemented, in this embodiment, by an integrator 112 and a triple integrator 114. The integrator 112 comprises an operational amplifier 120 and an integrating capacitor 122. The triple integrator 114 comprises an operational amplifier 124, integrating capacitors 126, 128 and 130, and resistors 131, 132, 134 and 136. As in the embodiment illustrated in Figure 2A, the clipper circuit 36 comprises four diodes 138, 140, 142 and 144 and a resistor 145. A summer 146 sums the two signals which pass through the spectrum tilter 24.

In the embodiment of the spectrum tilter 24 illustrated in Figure 3, the phase lag below $.1F_{BIT}$ approaches 360°: 90° for each integrating capacitor 122, 126, 128 and 130. The clipper 36 nullifies 270° of this phase lag by by-passing the capacitors 126, 128 and 130. Because the linear filter configuration of the embodiment of Figure 3 has two forward parallel signal paths meeting at the summer 146, it provides several benefits in spectrum tilter performance. The partial interference within the summer 146 between the two signal paths allows greater spectral tilt to be realized below approximately $.1F_{BIT}$ while maintaining the necessary phase margin (i.e., phase below 180°) in the frequency range $.1F_{BIT}$ to $F_{BIT}$. Since the clipper 36 operates only on the high phase leg of the spectrum tilter 24, the parallel signal path structure also insures low overall phase lag under sufficiently high signal level conditions, due to dominance of the low phase lag leg over the clipped high phase lag leg.

The enhanced delta modulation encoder 10 of the present invention may be implemented in numerous ways. For example, although the spectrum tilter 24 has been illustrated by embodiments employing three and four integrating circuits, the spectrum tilter 24 could be expanded to include any desired number (e.g., N, where N is an integer greater than or equal to 3) of integrating circuits as long as the clipper 36 (or several clippers) is connected across N − 1 of the integrating capacitors. In addition, the analog input signal can be introduced into the overall feedback loop of the enhanced delta modulation encoder 10 at a point inside the spectrum tilter 24, or at its output. Furthermore, the summer 20 of Figure 1A may be inverting or non-inverting at either of its inputs, and each of the elements in the feedback loop (the spectrum tilter 24, the 1 bit A/D converter 26, the sampling circuit 28 and the 1 bit D/A converter 34) may be inverting or non-inverting. The only constraint is that the feedback loop gain must be negative, so that signs except any one in the loop can be chosen arbitrarily. With respect to the internal decoder 22, the two pulse types which are generated by the internal decoder 22 may differ in height, width, shape, magnitude of area, and time of occurrence relative to a regular bit rate clock. One of the pulse types may be a null-pulse, i.e., the absence of a pulse, and the base line on the internal decoder output may be non-zero. A digital processor may be interposed at the output of the sampling circuit 28 so that the output of the digital processor is the digital output and also the input to the internal decoder 22.

The many features and advantages of the invention apparent from the detailed specification and thus it is intended to cover all such features and advantages of the system which fall within the scope of the appended claims. Further, since numerous modifications and changes will readily occur to those skilled in the art, it is not desired to limit the invention to the exact construction and operation shown and described and, accordingly, all suitable modifications and equivalents may be resorted to falling within the scope of the appended claims.

**Claims**

1. An analog-to-digital encoder for converting an analog input signal, having a predetermined frequency band of interest, to a digital output, including first means (20) for receiving the analog input signal and generating an analog dither signal, second means (26, 28) for generating the digital output, and third means (22) for feeding back the digital output to said first means (20) by generating an internal analog signal and providing the internal analog signal to said first means (20), said first means (20) adding the analog input signal and the internal analog signal to obtain the analog dither signal, characterized in that said analog-to-digital encoder further comprises:

a spectrum tilter (24), operatively connected to said first means (20), for receiving the analog dither signal and for generating a flattened analog signal, said spectrum tilter (24) having more than 180° of phase lag at certain frequencies within the frequency band of interest, said spectrum tilter (24) including means for preventing said analog-to-digital encoder from entering a limit cycle said second means (26, 28) generating the digital output on the basis of the flattened analog signal.

2. An analog-to-digital encoder as set forth in claim 1, wherein said spectrum tilter (24) comprises:

a first integrating circuit (38) operatively connected to said first means (20);

a second integrating circuit (40) operatively connected to said first integrating circuit (38);

a third integrating circuit (40) operatively connected to said second integrating circuit (40) and said second means (26, 28); and

a clipping circuit (36) operatively connected in parallel to said second and third integrating circuits (40).

3. An analog-to-digital encoder as set forth in claim 1, wherein said spectrum tilter (24) comprises:

a first integrating circuit (112) operatively connected to said first means (20);

a second integrating circuit (114) operatively connected to said first integrating circuit (112);

a third integrating circuit (114) operatively connected to said second integrating circuit (114);

a fourth integrating circuit (114) operatively connected to said third integrating circuit (114) and said second means (26, 28); and

a clipping circuit (36) operatively connected in parallel to said second, third and fourth integrating circuits (114).

4. An analog-to-digital encoder as set forth in claim 1, wherein said spectrum tilter (24) comprises:

at least three integrating circuits (38, 40) connected between said first means (20) and said second means (26, 28); and

a clipping circuit (36) connected in parallel to two of said at least three integrating circuits (40).

5. An analog-to-digital encoder as set forth in claim 1, wherein said spectrum tilter (24) comprises:

N integrating circuits (38, 40), where N is an integer greater than or equal to 3, connected between said first means (20) and said second means (26, 28); and

a clipping circuit (36) connected in parallel to N-1 of said N integrating circuits (40).

6. An analog-to-digital encoder for converting an analog input signal, having a predetermined frequency band of interest, to a digital output, including first means (20) for receiving the analog input signal and generating an analog dither signal, second means (26, 28) for generating a digital output, and a third means (22) for receiving the digital output and for generating an internal analog signal, characterized in that said analog-to-digital encoder further comprises;

a first spectrum tilter (24a), operatively connected to said first means (20) and said second means (26, 28), for receiving the analog dither signal and for generating a flattened analog signal; and

a second spectrum tilter (24b), operatively connected to said third means (22) and said first means (20), for receiving the internal analog signal and for generating a flattened internal analog signal, said first means (20) adding the analog input signal and the flattened internal analog signal to obtain the analog dither signal, said first and second spectrum tilters (24a, 24b) together generating more than 180° of phase lag at certain frequencies within the frequency band of interest, at least one of said first and second spectrum tilters (24a, 24b) including means for preventing said analog-to-digital encoder from entering a limit cycle.

7. An analog-to-digital encoder as set forth in claim 6, wherein said first spectrum tilter (24a) comprises:

a first integrating circuit operatively connected to said first means;

a second integrating circuit operatively connected to said first integrating circuit and said second means; and

a clipping circuit operatively connected in parallel to said first and second integrating circuits, and wherein said second spectrum tilter (24b) comprises a third integrating circuit operatively connected to said third means (22) and said first means (20).

8. An analog-to-digital encoder as set forth in claim 6, wherein said first spectrum tilter (24a) comprises;

N integrating circuits, where N is an integer, connected between said first means (20) and said second means (26, 28); and

a clipping circuit connected in parallel to said N integrating circuits, and wherein said second spectrum tilter (24b) comprises M integrating circuits, where M is an integer and where M + N is greater than or equal to 3.

9. An analog-to-digital encoder as set forth in any of claims 1 to 8, further comprising a digital processor, operatively connected to said second means (26, 28), for processing the digital output.

10. An analog-to-digital encoder as set forth in any of claims 1 to 8, further comprising timing means (30), operatively connected to said second means (26, 28) and said third means (22), for providing a first timing signal to said second means (26, 28) and for providing a second timing signal to said third means (22), wherein said second means (26, 28) generates the digital output in dependence upon said first timing signal and wherein said third means (22) generates the internal analog signal in dependence upon said second timing signal.

11. An analog-to-digital encoder as set forth in claim 10, wherein said third means (22) comprises a decoder circuit (22) connected to said timing means (30), said second means (26, 28) and said first means (20).

12. An analog-to-digital encoder as set forth in claim 11, wherein said decoder circuit (22) comprises a one bit digital-to-analog converter (34).

13. An analog-to-digital encoder as set forth in claim 11, wherein said second means (26, 28) comprises:

an analog-to-digital converter (26) operatively connected to said or said first spectrum tilter (24 or 24a); and

a sampling circuit (28) operatively connected to said analog-to-digital converter (26) and said decoder circuit (22).

14. An analog-to-digital encoder as set forth in claim 13, wherein said sampling circuit (28) comprises a flip-flop (76).

15. An analog-to-digital encoder as set forth in claim 14, wherein said analog-to-digital converter (26) is a one bit analog-to-digital converter (26).

16. An analog-to-digital encoder as set forth in claim 15, wherein said one bit analog-to-digital converter (26) is a comparator (72).

**Revendications**

1. Un codeur analogique-numérique destiné à convertir en un signal de sortie numérique un signal d'entrée analogique ayant une bande de fréquence intéressante prédéterminée, comprenant des premiers moyens (20) destinés à recevoir le signal d'entrée analogique et à générer un signal d'oscillation analogique, des seconds moyens (26, 28) destinés à générer le signal de sortie numérique, et des troisièmes moyens (22) destinés à renvoyer le signal de sortie numérique vers les premiers moyens (20), en générant un signal analogique interne et en appliquant le signal analogique interne aux premiers moyens (20), ces premiers moyens (20) additionnant le signal d'entrée analogique et le signal analogique interne pour former le signal d'oscillation analogique, caractérisé en ce que ce codeur analogique-numérique comprend en outre:

un dispositif d'inclinaison de spectre (24), connecté fonctionnellement aux premiers moyens (20), pour recevoir le signal d'oscillation analogique et pour générer un signal analogique aplati, ce dispositif d'inclinaison de spectre (24) ayant un retard de phase de plus de 180° à certaines fréquences dans la bande de fréquence intéressante, ce dispositif d'inclinaison de spectre (24) comprenant des moyens destinés à empêcher que le codeur analogique-numérique n'entre dans un cycle limite, et les seconds moyens (26, 28) générant le signal de sortie numérique sur la base du signal analogique aplati.

2. Un codeur analogique-numérique selon la revendication 1, dans lequel le dispositif d'inclinaison de spectre (24) comprend:

un premier circuit intégrateur (38) connecté fonctionnellement aux premiers moyens (20);

un second circuit intégrateur (40) connecté fonctionnellement au premier circuit intégrateur (38);

un troisième circuit intégrateur (40) connecté fonctionnellement au second circuit intégrateur (40) et aux seconds moyens (26, 28); et

un circuit écrêter (36) connecté fonctionnellement en parallèle sur les second et troisième circuits intégrateurs (40).

3. Un codeur analogique-numérique selon la revendication 1, dans lequel le dispositif d'inclinaison de spectre (24) comprend:

un premier circuit intégrateur (112) connecté fonctionnellement aux premiers moyens (20);

un second circuit intégrateur (114) connecté fonctionnellement au premier circuit intégrateur (112);

un troisième circuit intégrateur (114) connecté fonctionnellement au troisième circuit intégrateur (114) et aux seconds moyens (26, 28); et

un circuit écrêter (36) connecté fonctionnellement en parallèle sur les second, troisième et quatrième circuits intégrateurs (114).

4. Un codeur analogique-numérique selon la revendication 1, dans lequel le dispositif d'inclinaison de spectre (24) comprend:

au moins trois circuits intégrateurs (38, 40) connectés entre les premiers moyens (20) et les seconds moyens (26, 28); et

un circuit écrêteur (36) connecté en parallèle sur deux des circuits intégrateurs (40) qui sont au moins au nombre de trois.

5. Un codeur analogique-numérique selon la revendication 1, dans lequel le dispositif d'inclinaison de spectre (24) comprend:

N circuits intégrateurs (38, 40), en désignant par N un nombre entier supérieur ou égal à 3, connectés entre les premiers moyens (20) et les seconds moyens (26, 28); et

un circuit écrêteur (36) connecté en parallèle sur N − 1 des N circuits intégrateurs (40).

6. Un codeur analogique-numérique destiné à convertir en un signal de sortie numérique un signal d'entrée analogique ayant une bande de fréquence intéressante prédéterminée, comprenant des premiers moyens (20) destinés à recevoir le signal d'entrée analogique et à générer un signal d'oscillation analogique, des seconds moyens (26, 28) destinés à générer un signal de sortie numérique, et des troisièmes moyens (22) destinés à recevoir le signal de sortie numérique et à générer un signal analogique interne, caractérisé en ce que ce codeur analogique-numérique comprend en outre:

un premier dispositif d'inclinaison de spectre (24a), connecté fonctionnellement aux premiers moyens (20) et aux seconds moyens (26, 28), pour recevoir le signal d'oscillation analogique et pour générer un signal analogique aplati; et

un second dispositif d'inclinaison de spectre (24b), connecté fonctionnellement aux troisièmes moyens (22) et aux premiers moyens (20), pour recevoir le signal analogique interne et pour générer un signal analogique interne aplati, les premiers moyens (20) additionnant le signal d'entrée analogique au signal analogique interne aplati pour former le signal d'oscillation analogique, les premier et second dispositifs d'inclinaison de spectre (24a, 24b) produisant conjointement un retard de phase de plus de 180° à certaines fréquences dans la bande de fréquence intéressante, et l'un au moins des premier et second dispositifs d'inclinaison de spectre (24a, 24b) comprenant des moyens destinés à empêcher que le codeur analogique-numérique n'entre dans un cycle limite.

7. Un codeur analogique-numérique selon la revendication 6, dans lequel le premier dispositif d'inclinaison de spectre (24a) comprend:

un premier circuit intégrateur connecté fonctionnellement aux premiers moyens;

un second circuit intégrateur connecté fonctionnellement au premier circuit intégrateur et aux seconds moyens; et

un circuit écrêteur connecté fonctionnellement en parallèle sur les premier et second circuits intégrateurs, et dans lequel le second dispositif d'inclinaison de spectre (24b) comprend un troisième circuit intégrateur connecté fonctionnellement aux troisièmes moyens (22) et aux premiers moyens (20).

8. Un codeur analogique-numérique selon la revendication 6, dans lequel le premier dispositif d'inclinaison de spectre (24a) comprend:

N circuits intégrateurs, en désignant par N un nombre entier, connectés entre les premiers moyens (20) et les seconds moyens (26, 28); et

un circuit écrêteur connecté en parallèle sur les N circuits intégrateurs, et dans lequel le second dispositif d'inclinaison de spectre (24b) comprend M circuits intégrateurs, en désignant par M un nombre entier et avec M + N supérieur ou égal à 3.

9. Un codeur analogique-numérique selon l'une quelconque des revendications 1 à 8, comprénant en outre un dispositif de traitement numérique, connecté fonctionnellement aux seconds moyens (26, 28), pour traiter le signal de sortie numérique.

10. Un codeur analogique-numérique selon l'une quelconque des revendications 1 à 8, comprenant en outre des moyens de génération de signaux de temps (30) connectés fonctionnellement aux seconds moyens (26, 28) et aux troisièmes moyens (22), pour appliquer un premier signal de temps aux seconds moyens (26, 28) et pour appliquer un second signal de temps aux troisièmes moyens (22), dans lequel les seconds moyens (26, 28) génèrent le signal de sortie numérique sous la dépendance du premier signal de temps et dans lequel les troisièmes moyens (22) génèrent le signal analogique interne sous la dépendance du second signal de temps.

11. Un codeur analogique-numérique selon la revendication 10, dans lequel les troisièmes moyens (22) comprennent un circuit décodeur (22) connecté aux moyens de génération de signaux de temps (30), aux seconds moyens (26, 28) et aux premiers moyens (20).

12. Un codeur analogique-numérique selon la revendication 11, dans lequel le circuit décodeur (22) consiste en un convertisseur numérique-analogique à un bit (34).

13. Un codeur analogique-numérique selon la revendication 11, dans lequel les seconds moyens (26, 28) comprennent:

un convertisseur analogique-numérique (26) connecté fonctionnellement au dispositif d'inclinaison de spectre ou au premier dispositif d'inclinaison de spectre (24 ou 24a); et

un circuit d'échantillonnage (28) connecté fonctionnellement au convertisseur analogique-numérique (26) et au circuit décodeur (22).

14. Un codeur analogique-numérique selon la revendication 13, dans lequel le circuit d'échantillonnage (28) comprend une bascule (76).

15. Un codeur analogique-numérique selon la revendication 14, dans lequel le convertisseur analogique-numérique (26) est un convertisseur analogique-numérique à un bit (26).

16. Un convertisseur analogique-numérique selon la revendication 15, dans lequel le convertisseur analogique-numérique à un bit (26) est un comparateur (72).

**Patentansprüche**

1. Ein Analog/Digital-Kodierer zur Umwandlung eines analogen Eingangssignals mit vorgegebenem, hier interessierendem Frequenzband in ein digitales Ausgangssignal, mit

— einer ersten Einrichtung (20) zur Aufnahme des analogen Eingangssignals und zur Erzeugung eines analogen Zittersignals;

— einer zweiten Einrichtung (26, 28) zur Erzeugung des digitalen Ausgangssignals; und mit

— einer dritten Einrichtung (22) zur Rückführung des digitalen Ausgangssignals zur ersten Einrichtung durch Erzeugen eines internen Analogsignals und Weiterleitung des internen Analogsignals zur ersten Einrichtung (20), wobei die erste Einrichtung (20) das analoge Eingangssignal und das interne Analogsignal addiert, um das analoge Zittersignal zu erzeugen,

dadurch gekennzeichnet, daß zusätzlich eine Spektrum-Abschrägeinrichtung (24) vorhanden ist, die wirksam mit der ersten Einrichtung (20) verknüpft ist, um das analoge Zittersignal aufzunehmen und um ein abgeflachtes Analogsignal zu erzeugen, wobei die Spektrum-Abschrägeinrichtung (24) bei bestimmten Frequenzen innerhalb des hier interessierenden Frequenzbandes eine Phasennacheilung von mehr als 180° hat, und wobei zu der Spektrum-Abschrägeinrichtung (24) weiterhin eine Einrichtung gehört, welche verhindert, daß der Analog/Digital-Kodierer in einen Grenzzyklus gelangt, wobei die zweite Einrichtung (26, 28) das digitale Ausgangssignal auf der Basis des abgeflachten Analogsignals erzeugt.

2. Der Analog/Digital-Kodierer nach Anspruch 1, dadurch gekennzeichnet, daß zu der Spektrum-Abschrägeinrichtung (24) gehören:

— ein erster Integrierkreis (38), der wirksam mit der ersten Einrichtung (20) verknüpft ist;

— ein zweiter Integrierkreis (40), der wirksam mit dem ersten Integrierkreis (38) verknüpft ist;

— ein dritter Integrierkreis (40), der wirksam mit dem zweiten Integrierkreis (40) und mit der zweiten Einrichtung (26, 28) verknüpft ist; und

— ein Begrenzungskreis (36), der parallel zu dem zweiten Integrierkreis (40) und zu dem dritten Integrierkreis (40) geschaltet ist.

3. Der Analog/Digital-Kodierer nach Anspruch 1, dadurch gekennzeichnet, daß zu der Spektrum-Abschrägeinrichtung (24) gehören:

— ein erster Integrierkreis (112), der wirksam mit der ersten Einrichtung (20) verknüpft ist;

— ein zweiter Integrierkreis (114), der wirksam mit dem ersten Integrierkreis (112) verknüpft ist;

— ein dritter Integrierkreis (114), der wirksam mit dem zweiten Integrierkreis (114) verknüpft ist;

— ein vierter Integrierkreis (114), der wirksam mit dem dritten Integrierkreis (114) und mit der zweiten Einrichtung (26, 28) verknüpft ist; und

— ein Begrenzungskreis (36), der parallel zu dem zweiten, dem dritten und dem vierten Integrierkreis (114) geschaltet ist.

4. Der Analog/Digital-Kodierer nach Anspruch 1, dadurch gekennzeichnet, daß zu der Spektrum-Abschrägeinrichtung (24) gehören:

— wenigstens drei Integrierkreise (38, 40), welche zwischen die erste Einrichtung (20) und die zweite Einrichtung (26, 28) geschaltet sind; und

— ein Begrenzungskreis (36), der parallel zu wenigstens zwei Integrierkreisen von diesen drei Integrierkreisen (40) geschaltet ist.

5. Der Analog/Digital-Kodierer nach Anspruch 1, dadurch gekennzeichnet, daß zu der Spektrum-Abschrägeinrichtung (24) gehören:

— N Integrierkreise (38, 40), wobei N eine ganze Zahl größer oder gleich 3 ist, welche Integrierkreise zwischen die erste Einrichtung (20) und die zweite Einrichtung (26, 28) geschaltet sind; und

— ein Begrenzungskreis (36), der parallel zu (N-1) Integrierkreisen von diesen N Integrierkreisen (40) geschaltet ist.

6. Ein Analog/Digital-Kodierer zur Umwandlung eines analogen Eingangssignals mit vorgegebenem, hier interessierendem Frequenzband in ein digitales Ausgangssignal, mit

— einer ersten Einrichtung (20) zur Aufnahme des analogen Eingangssignals und zur Erzeugung eines analogen Zittersignals;

— einer zweiten Einrichtung (26, 28) zur Erzeugung eines digitalen Ausgangssignals; und mit

— einer dritten Einrichtung (22) zur Aufnahme des digitalen Ausgangssignals und zur Erzeugung eines internen Analogsignals,

dadurch gekennzeichnet, daß zu dem Analog/Digital-Kodierer weiterhin gehören:

— eine erste Spektrum-Abschrägeinrichtung (24a), die wirksam mit der ersten Einrichtung (20) und mit der zweiten Einrichtung (26, 28) verknüpft ist, um das analoge Zittersignal aufzunehmen und um ein abgeflachtes Analogsignal zu erzeugen; und

— eine zweite Spektrum-Abschrägeinrichtung (24b), die wirksam mit der dritten Einrichtung (22) und mit der ersten Einrichtung (20) verknüpft ist, um das interne Analogsignal aufzunehmen und um ein abgeflachtes, internes Analogsignal zu erzeugen, wobei die erste Einrichtung (20) das analoge Eingangssignal und das abgeflachte interne Analogsignal addiert, um das analoge Zittersignal zu bilden, wobei weiterhin die erste und die zweite Spektrum-Abschrägeinrichtungen (24a, 24b) zusammen bei bestimmten Frequenzen innerhalb des hier interessierenden Frequenzbandes eine Phasennacheilung von mehr als 180° erzeugen und wobei wenigstens eine der beiden Spektrum-Abschrägeinrichtung (24a, 24b) eine Einrichtung aufweist, welche verhindert, daß der Analog/Digital-Kodierer in einen Grenzzyklus gelangt.

7. Der Analog/Digital-Kodierer nach Anspruch 6, dadurch gekennzeichnet, daß zu der ersten Spektrum-Abschrägeinrichtung (24a) gehören:

— ein erster Integrierkreis, der wirksam mit der ersten Einrichtung verknüpft ist;

— ein zweiter Integrierkreis, der wirksam mit dem ersten Integrierkreis und mit der zweiten Einrichtung verknüpft ist; und

— ein Begrenzungskreis, der parallel zu dem ersten und zu dem zweiten Integrierkreis geschaltet ist, und wobei die zweite Spektrum-Abschrägeinrichtung (24b) einen dritten Integrierkreis aufweist, der wirksam mit der dritten Einrichtung (22) und mit der ersten Einrichtung (20) verknüpft ist.

8. Der Analog/Digital-Kodierer nach Anspruch 6, dadurch gekennzeichnet, daß zu der ersten Spektrum-Abschrägeinrichtung (24a) gehören:

— N Integrierkreise, wobei N eine ganze Zahl ist, welche Integrierkreise zwischen die erste Einrichtung (20) und die zweite Einrichtung (26, 28) geschaltet sind; und

— ein Begrenzungskreis, der parallel zu den N Integrierkreisen geschaltet ist; und

— die zweite Spektrum-Abschrägeinrichtung (24b) M Integrierkreise aufweist, wobei M eine ganze Zahl ist, und wobei die Summe (M + N) größer oder gleich 3 ist.

9. Der Analog/Digital-Kodierer nach einem der Ansprüche 1 bis 8, dadurch gekennzeichnet, daß zusätzlich ein Digital-Processor vorhanden ist, der wirksam mit der zweiten Einrichtung (26, 28) verknüpft ist, um das digitale Ausgangssignal zu verarbeiten.

10. Der Analog/Digital-Kodierer nach einem der Ansprüche 1 bis 8, dadurch gekennzeichnet, daß zusätzlich eine Zeitsteuereinrichtung (30) vorhanden ist, die wirksam mit der zweiten Einrichtung (26, 28) und mit der dritten Einrichtung (22) verknüpft ist, um die zweite Einrichtung (26, 28) mit einem ersten Zeitsignal zu versorgen, und um die dritte Einrichtung (22) mit einem zweiten Zeitsignal zu versorgen, wobei die zweite Einrichtung (26, 28) das digitale Ausgangssignal in Abhängigkeit von dem ersten Zeitsignal erzeugt, und wobei die dritte Einrichtung (22) das interne Analogsignal in Abhängigkeit von dem zweiten Zeitsignal erzeugt.

11. Der Analog/Digital-Kodierer nach Anspruch 10, dadurch gekennzeichnet, daß zu der dritten Einrichtung (22) ein Dekodierkreis (22) gehört, der wirksam mit der Zeitsteuereinrichtung (30), mit der zweiten Einrichtung (26, 28) und mit der ersten Einrichtung (20) verknüpft ist.

12. Der Analog/Digital-Kodierer nach Anspruch 11, dadurch gekennzeichnet, daß zu dem Dekodierkreis (22) ein Ein-Bit-Digital/Analog-Wandler (34) gehört.

13. Der Analog/Digital-Kodierer nach Anspruch 11, dadurch gekennzeichnet, daß zu der zweiten Einrichtung (26, 28) gehören:

— ein Analog/Digital-Wandler (26), der wirksam mit der Spektrum-Abschrägeinrichtung (24) oder mit der ersten Spektrum-Abschrägeinrichtung (24a) verknüpft ist; und

— ein Abtastkreis (28), der wirksam mit dem Analog/Digital-Wandler (26) und mit dem Dekodierkreis (22) verknüpft ist.

14. Der Analog/Digital-Kodierer nach Anspruch 13, dadurch gekennzeichnet, daß der Abtastkreis (28) ein Flipflop (76) aufweist.

15. Der Analog/Digital-Kodierer nach Anspruch 14, dadurch gekennzeichnet, daß der Analog/Digital-Wandler (26) ein Ein-Bit-Analog/Digital-Wandler (26) ist.

16. Der Analog/Digital-Kodierer nach Anspruch 15, dadurch gekennzeichnet, daß der Ein-Bit-Analog/Digital-Wandler (26) ein Komparator (72) ist.

FIG. IA.

FIG. 3.

FIG. 4.

FIG. 2A.

FIG. 2B.

SPECTRUM TILTER

1 BIT A/D

SAMPLER

FIG. 5.

0 081 568

*FIG. 1B.*

*FIG. 6.*

*FIG. 7.*